# EUROPEAN PATENT SPECIFICATION

(11) **EP 1 417 151 B1**
(45) Date of publication and mention of the grant of the patent: **03.01.2007**
(21) Application number: 02712117.7
(22) Date of filing: 18.02.2002
(51) Int. Cl.: B81B 3/00, G01F 1/684, H05B 1/00

(54) **METHOD FOR THE FABRICATION OF SUSPENDED POROUS SILICON MICROSTRUCTURES AND APPLICATION IN GAS SENSORS**
VERFAHREN ZUR HERSTELLUNG AUFGEHÄNGTER PORÖSER SILIZIUMMIKROSTRUKTUREN UND ANWENDUNG IN GASSENSOREN
PROCEDE DE FABRICATION DE MICROSTRUCTURES EN SILICIUM POREUX EN SUSPENSION ET LEUR MISE EN OEUVRE DANS DES CAPTEURS DE GAZ

(30) Priority: 31.07.2001 GR 2001100378
(43) Date of publication of application: 12.05.2004
(73) Proprietor: NCSR "DEMOKRITOS", 153 10 Aghia Paraskevi, Athens (GR); Tsamis, Christos, 153 10 Aghia Paraskevi Athens (GR); Tserepi, Angeliki, 153 10 Aghia Paraskevi Athens (GR); Nassiopoulou, Androula G., 153 10 Aghia Paraskevi Athens (GR)
(72) Inventor: TSAMIS, Christos, NCSR "Demokritos", 153 10 Aghia Paraskevi, Athens (GR); TSEREPI, Angeliki, NCSR "Demokritos", 153 10 Aghia Paraskevi, Athens (GR); NASSIOPOULOU, Androula, G., NCSR "Demokritos", 153 10 Aghia Paraskevi, Athens (GR)
(74) Representative: Malamis, Alkisti-Irene
(86) International application number: PCT/GR2002/000008
(87) International publication number: WO 2003/011747

(56) References cited:
- EP-A- 0 819 935
- WO-A-98/50763
- MACCAGNANI P ET AL: "Thick porous silicon thermo-insulating membranes for gas sensor applications" SENSORS AND MATERIALS, 1999, MYU, JAPAN, vol. 11, no. 3, pages 131-147, XP008001539 ISSN: 0914-4935 cited in the application
- KOLEV S D ET AL: "Thermal modelling of a porous silicon-based pellistor-type catalytic flammable gas sensor with two supporting beams" MICROELECTRONICS JOURNAL, MACKINTOSH PUBLICATIONS LTD. LUTON, GB, vol. 31, no. 5, May 2000 (2000-05), pages 339-342, XP004193977 ISSN: 0026-2692
- PARBUKOV A N ET AL: "The production of a novel stain-etched porous silicon, metallization of the porous surface and application in hydrocarbon sensors" INTERNATIONAL CONFERENCE ON ELECTRONIC MATERIALS AND EUROPEAN MATERIALS RESEARCH SOCIETY (EMRS-IUMRS ICEM 2000) SPRING MEETING, SYMPOSIUM E: CURRENT TRENDS IN NANOTECHNOLOGIES, SAN FRANCISCO, CA, USA, APRIL 2000, vol. C15, no. 1-2, pages 121-123, XP002193596 Materials Science & Engineering C, Biomimetic and Supramolecular Systems, 2001, Elsevier, Netherlands ISSN: 0928-4931
- LAMMEL G ET AL: "Free-standing, mobile 3D porous silicon microstructures" SENSORS AND ACTUATORS A, ELSEVIER SEQUOIA S.A., LAUSANNE, CH, vol. 85, no. 1-3, 25 August 2000 (2000-08-25), pages 356-360, XP004214496 ISSN: 0924-4247
- LI Y X ET AL: "SIMPLE - A technique of silicon micromachining using plasma etching" SENSORS AND ACTUATORS A, ELSEVIER SEQUOIA S.A., LAUSANNE, CH, vol. 57, no. 3, 1 December 1996 (1996-12-01), pages 223-232, XP004081084 ISSN: 0924-4247 cited in the application
- BARATTO ET AL: 'Front-side micromachined porous silicon nitrogen dioxide gas sensor' THIN SOLID FILMS vol. 391, 16 June 2001, SWITZERLAND, pages 261 - 264, XP004246727

## Description

### DESCRIPTION OF THE INVENTION

### Field of the Invention

This invention relates to a method of fabricating suspended porous silicon membranes and to devices made employing this method.

### Description of the related art

For the fabrication of micromachined gas sensors, a lot of effort has focused on the development of methodologies for the formation of membranes used as support for the heater. In particular, two different structures have been utilized (Simon et al., Sensors and Actuators B 73, p.1, 2001): The closed-type membrane, where the membrane overlaps the silicon substrate along its periphery and the suspended-type membrane (also called spider-type and micro hot-plate). In the latter, the membrane element is connected to the Si substrate by means of supporting beams, and the central portion of the membrane is suspended over a cavity that is etched in the substrate.

The closed-type membrane is formed by means of anisotropic (crystallographic) etching of silicon from the back side of the wafer. Wet etchants like KOH and EDP are typically used. Appropriate etch stops for these etchants are silicon nitride, silicon oxide or Boron- doped silicon. For the formation of the membrane, two different techniques have been utilized. The first, which is more popular, uses silicon oxide and/or silicon nitride as membrane and insulation materials to obtain membranes of typical thickness between 1 and 2 µm [(a) G. Sberveglieri et al. Microsyst. Technolog., p.183, 1997, (b) J. Gardner, Sens. Actuators B 26/27, p. 135, 1995 and (c) D. Lee, Sens. Actuators B 49, p.147, 1996]. The second method, which has been applied recently, uses nitrided porous silicon of thickness between 25 and 30 µm (Maccagnani et al., Proceed. of the 13^{th} European Conference on Solid-State Transducers, The Netherlands 1999) that can be obtained by silicon anodization and subsequent nitridation. Silicon oxide, silicon nitride and nitrided porous silicon all possess low thermal conductivities and can provide good thermal isolation between the heated active area and the membrane rim.

On the other hand, the suspended-type membrane is completely processed from the front-side. Therefore, the suspended membrane is often said to be more compatible with CMOS processing (Gaitan et al., US Patent. 5,464,966). The suspended membrane is either formed by anisotropic wet etching with KOH or EDP from the front side or by sacrificial etching of oxide layers. Sacrificial etching of porous silicon is another possibility to obtain suspended membranes (Nassiopoulou et al., Application No PCT/GR97/00040, published by WIPO 12/11/1998 as WO 98/50763. Suspended polycrystalline and monocrystalline membranes have been fabricated using this technique by Kaltsas and Nassiopoulou [(α) G. Kaltsas and A.G. Nassiopoulou, Mat. Res. Soc. Symp. Proc., 459, p. 249, 1997, (β) G. Kaltsas and A. G. Nassiopoulou, Sens. Actuators: A65, p.175, 1998] and suspended nitride membranes by Gardeniers et al (J. G. E. Gardeniers et al., Sens. Actuators A60, p. 235, 1997). The typical lateral dimensions of suspended membranes range between 100 and 200 µm.

The use of suspended membranes is generally preferred compared to the closed-type membranes. The reason is that the thermal losses from the suspended-type membrane are minimized, since they occur only through the supporting beams of the membrane, compared to the closed membrane where thermal losses occur along its periphery.

Highly porous silicon (with porosity ~65%) has very good thermal properties similarly to silicon oxide. In sensor applications, it has been used in two ways: as a material for local thermal isolation on a silicon substrate [(a) Nassiopoulou et al., Application No PCT/GR97/00040 published by WIPO 12/11/1998, (b) G. as WO 98/50763 Kaltsas and A.G Nassiopoulou, Sens. Actuators A 76, p. 133, 1999] and as sacrificial layer for the formation of suspended membranes. Recently, nitrided porous silicon membranes were fabricated using backside etching. Maccagnani et al. (Maccagnani Proc. of the 13^{th} European Conference on Solid-State Transducers, The Netherlands, 1999) fabricated closed-type, nitrided porous silicon membrane, by using backside etch with KOH. The disadvantages of the proposed method are the need for double-side alignment before the bulk silicon etching from the back side and the need for more space due to the sloped side-walls (lateral dimension needed to form a membrane is larger by 40%). Plasma etching techniques like high aspect ratio silicon etching which is capable of forming vertical walls might therefore be an alternative to wet etching, allowing for a higher number density of sensors on a wafer compared to wet etching techniques. An alternative process for the fabrication of closed type membranes using front side micromachining technique is proposed by Baratto et al. (C. Baratto, Thin Solid Films, p. 261, 2001), based on the electropolishing of the silicon substrate after the formation of the porous silicon layer in order to form a cavity beneath the porous silicon. However in the case of closed type membranes, the thermal losses due to the membrane support area are increased compared to suspended membranes which have reduced contact area with the substrate, as stated previously [(a) G. Kaltsas and A.G. Nassiopoulou, Mat. Res. Soc. Symp. Proc., 459, p. 249, 1997, (b) J. G. E. Gardeniers et al., Sens. Actuators A60, p. 235, 1997].

Bulk silicon micromachining by plasma etching has been successfully used for the release of lightly doped Si structures overlaying a buried heavily doped n⁺ layer. The method is based on the high lateral etching rate of the n⁺ layer in contrast to the anisotropic etching of lightly doped Si in Cl₂BCl₃ plasmas (Y.X. Li, *et. al.,* Sensors and Actuators A57, p. 223, 1996). However, due to the relatively slow lateral etching of heavily doped n⁺ layer and the relatively small selectivity of the process with respect to masking material (PECVD oxide layer), the lateral dimension of the released structure was limited to about 4 µm. In addition, a combination of high aspect ratio anisotropic and isotropic etching in F-based plasmas has been employed for the release of freestanding microcantilevers and bridges from multi-layer substrates (Si-SiO₂-polySi-SiO₂-Si sandwiched wafers) (C. Cui et al., Sensors and Actuators A70, p.61, 1998). In this case, the released structures remain intact from the isotropic etching process, as they are protected by SiO₂ layers or fluorocarbon plasma deposited layers. Although this method offers the possibility of fabrication and release of high aspect ratio microstructures, it is based on the complicated process of fabrication of multi-layer substrates. Generally speaking, the release of single-crystal silicon structures from the substrate through the front side of the wafer can be achieved by means of a combined directional and isotropic silicon dry etch if the structures are protected on the sides by a Si-etching selective mask such as for example SiO₂ (F. Ayazi, et. al. JMEMS 9(3), p. 288, 2000). In the present invention, the released structure is made of porous Si, which simplifies extremely the process : The high selectivity of the used isotropic Si etching process with respect to porous Si makes unnecessary any protection of the structure to be released.

MACCAGNAMI P ET AL: "Thick porous silicon thermo-insulating membranes for gas sensor applications" SENSORS AND MATERIALS, 1999, MY, JAPAN, Vol. 11, no. 3, pages 131-147, ISSN: 0914-4935 discloses the fabrication of a closed type porous silicon membrane in contact with the silicon substrate along its perimeter. During formation of the membrane, silicon etching is performed from the back side of the wafer in order to form a mono-crystalline silicon membrane and, subsequently, anodization is performed to form the porous silicon membrane.

KOLEV S D ET AL: "Thermal modeling of a porous silicon-based pellisor-type catalytic flammable gas sensor with two supporting beams" MICOELECTRONICS JOURNAL, MACKINTOSH PUBLICATIONS LTD., LUTON, GB, vol. 31, no. 5, May 2000 (2000-05), pages 339-342, ISSN: 0026-2692 discloses a gas sensor including a membrane of silicon nitride suspended by two beams. An n-silicon heater and a porous silicon layer, both rectangular in shape, are provided on the membrane.

PARBUKOV A N ET AL: "The production of a novel strain-etched porous silicon, metallization of the porous surface and application in hydrocarbon sensors" INTERNATIONAL CONFERENCE ON ELECTRONIC MATERIAL AND EUROPEAN MATERIAL RESEARCH SOCIETY (EMRS-IUMRS ICEM 2000) SPRING MEETING, SYMPOSIUM E: CURRENT TRENDS IN NANOTECHNOLOGIES, SAN FRANCISCO, CA, USA, APRIL 2000, vol. C15, no. 1-2, pages 121-123, Materials Science & Engineering C, Biomimetic and Supramolecular Systems, 2001, Elsevier, Netherlands ISSN: 0928-4931 discloses a gas sensor based on the detection of heat produced during the catalytic combustion of the gas on the catalytic material. Porous silicon is formed on top of a closed-type membrane and a multilayer silicon membrane is subsequently doped with Pt in order to be used as a catalytic material for has combustion.

BARATTO ET AL.: "Front-side micromachined porous silicon nitrogen dioxide gas sensor" Thin Solid Films, vol. 391, 16 June 2001 (2001-06-16), pages 261-264, discloses a gas sensor with a closed porous silicon membrane suspended by a silicon nitride layer and a SiC layer. An air gap below the porous silicon membrane is obtained by electropolishing.

### Summary of the invention

It is an object of this invention to provide a method of fabricating suspended porous silicon membranes in the form of bridges or cantilevers, based on front side micromachining by means of dry etching techniques for the membrane release.

It is yet another object of this invention to provide a method for the fabrication of gas sensors, using suspended porous silicon membranes.

It is yet another object of this invention to provide a method for the fabrication of thermal conductivity sensors, using a heater on top of suspended porous silicon membranes.

The methodology that is described in the present invention gives the ability to utilize membranes for thermal sensors that combine two major innovations:
a) The ability to fabricate suspended Porous Silicon membranes, in the form of bridges or cantilevers, with good mechanical strength (compared to SiO₂ or Si₃N₄. membranes) and minimal thermal losses compared to the closed-type membranes.
b) The use of front side micromachining techniques for the fabrication of the suspended porous silicon structures with maximum device density.

According to an aspect of the invention there is provided front-side silicon micromachining process as claimed in Claim 1. According to another aspect of the invention there is provided a gas sensor device as claimed in Claim 3.

### Brief description of drawings

Figs. 1A through 1C are cross sectional schematic drawings illustrating the method for the fabrication of suspended Porous Silicon Membranes.
Figs. 2A to 2C are plan view schematic drawings of various Porous Silicon membranes.
Figs. 3A through 3C are cross sectional schematic drawings illustrating the process for the fabrication of a calorimetric type gas sensor, using a heater and/or a resistor as a thermal sensing element.
Fig. 4 Plan view schematic of a calorimetric type sensor.
Figs. 5A through 5C are cross sectional schematic drawings illustrating the process for the fabrication of a conductometric type gas sensor
Fig 6 is cross sectional schematic drawings illustrating a thermal conductivity sensor.

### Description of the preferred embodiments

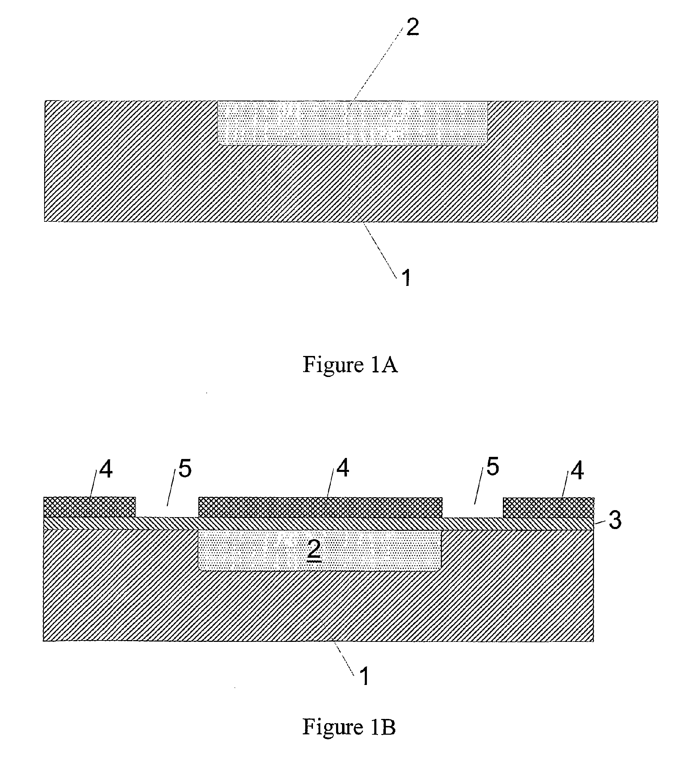

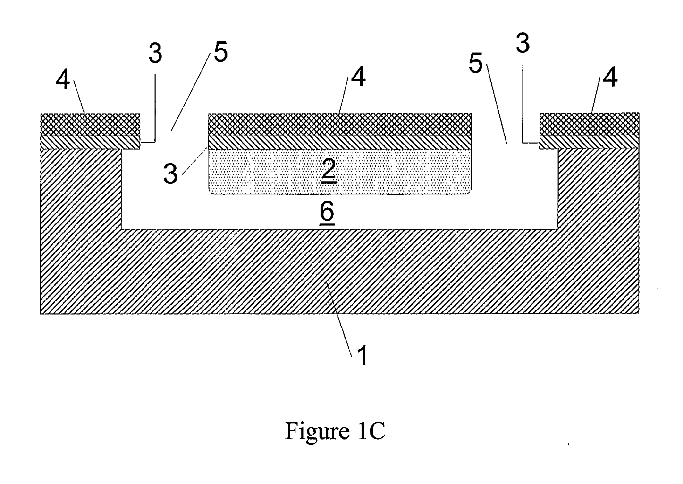

Figs. 1A through 1C are schematic drawings illustrating the fabrication process of suspended Porous Silicon membranes. As the base material (1), doped monocrystalline or polycrystalline silicon is used. The dopant concentration in the substrate can be either n type or p type with concentrations greater that 10¹⁴cm⁻². Porous silicon (2) is formed in predefined areas of the said substrate. Various masking techniques have been used for the local formation of porous silicon. These techniques include deposition and patterning of various layers such as Si₃N₄, SiO₂, SiGe, SiC, polycrystalline silicon and combination of them as well as ion implantation techniques. The masking material or method for the local patterning of porous silicon is not a limiting factor for the method described in this invention.

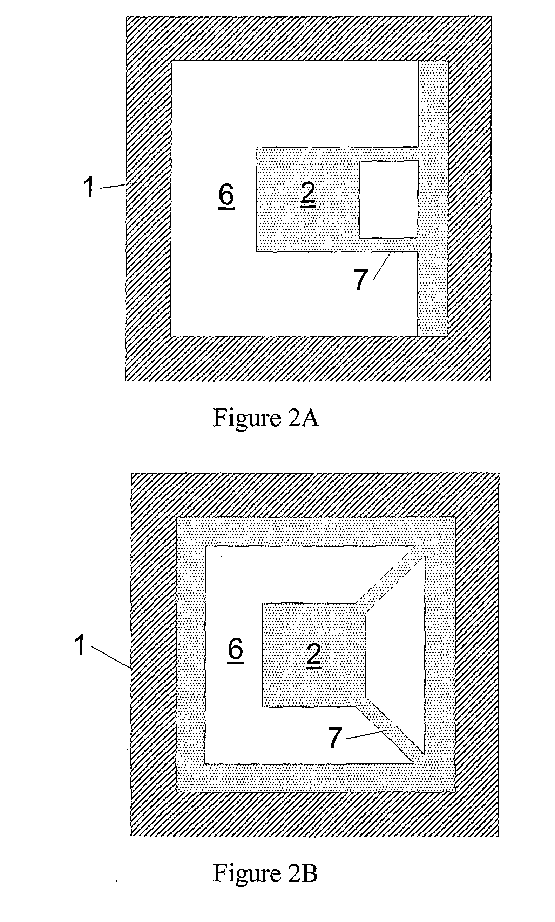

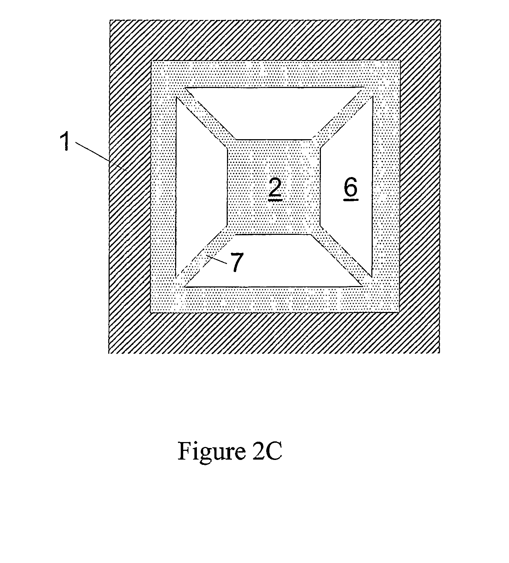

Fig. 1A shows the substrate (1) and the defined Porous Silicon area (2). The mask for the local formation of Porous Silicon (not shown in figure 1A), may consist of a silicon dioxide layer and a polysilicon layer, according to one of the embodiments of the present invention. After the formation of the porous silicon areas, an insulating layer (3) is deposited on top of porous silicon (Fig 1B). The insulating layer (3) can be SiO₂ or Si₃N₄ or any combination of them. Subsequently, photoresist (4) is deposited on top of the wafer and etch windows (5) are opened using standard photolithography techniques. Depending on the design and the geometrical characteristics of the Porous Silicon membrane (2), the etch windows (5) are placed at the periphery of the porous silicon membrane (2) or at predefined places inside the membrane (Fig 1B). The removal of the insulating layers (3) and the mask, that is used for the local formation of porous silicon (2) can be achieved either by wet or dry etching techniques. Then the etch windows (5) extend down to the silicon substrate (1) adjacent to the porous silicon membrane (2). At this point, the silicon material from underneath the porous structure is removed by a combination of anisotropic / isotropic dry etching processes. Experiments that have been performed by the inventors showed that the etching rate of thermally treated porous silicon is about 100 times slower compared to the etching rate of silicon substrate for anisotropic and even slower for isotropic etching. For this reason the porous membrane remains virtually unaffected during the lateral plasma etching of the silicon substrate. Fig. 1C shows a cross section schematic of the released Porous Silicon membrane where the cavity (6) formed under the porous silicon (2) is shown. Figs. 2A to Fig 2C show various top view designs of suspended Porous Silicon structures, where we can see the silicon substrate (1), the porous silicon membrane (2) and the porous silicon supporting beams (7). The membrane is suspended over the cavity (6).

One of the key parameters for the successful implementation of the methodology that is described in the present invention is the optimization of dry etching conditions. Various processes can be used provided that the etching conditions are selected in such a way that the process is highly selective to silicon etching compared to Porous Silicon etching. For example, an F-rich gas as sulfur hexafluoride is used which has a flow of between 100-300 seem and a processing pressure between 1 and 10 Pa. The plasma generation preferably takes place with a high frequency supply (13.56 MHz) at outputs between 500 W and 2000 W. At the same time, a low substrate voltage for ion acceleration is supplied to the substrate electrode. The substrate voltage is preferably between 30 and 60 V.

One of the phenomena that is observed during dry etching, is that the etch rate depends on the dimensions of the etch windows. This phenomenon has been observed in the past in high aspect ratio Si etching and is known as RIE lag. Experiments that were performed by the inventors demonstrated that this influence exists also for lateral etching of Si. However this influence of the dimension of the etch window on the Si etch rate does not impose any constraints on the method that is described in the present invention. On the contrary, by carefully designing the position and the dimensions of the etch windows, it is possible to benefit from this dependence and release selectively suspended microstructures of certain shapes, and sizes.

Another key parameter for the successful implementation of the proposed methodology is the optimization of mechanical properties of the characteristics of the Porous Silicon layer. It is obvious that the structural characteristics of the Porous Silicon membranes (porosity, thickness, pore size) and the, subsequent thermal treatment have to be optimized according to the design and geometrical characteristics of the layer. With the aid of the methodology proposed in the present invention, suspended Porous Silicon membranes have been formed with thickness ranging from few nm to several micrometers and with size up to several millimeters.

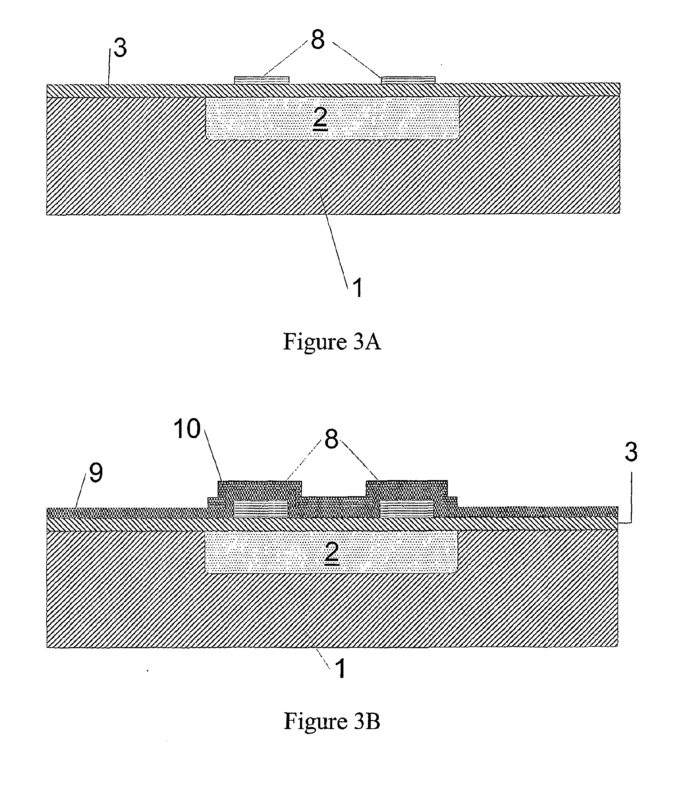

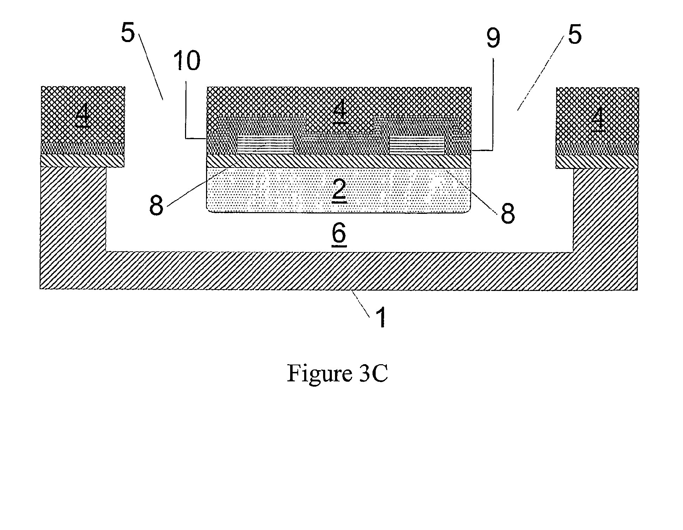

In another embodiment of the present invention, a calorimetric type gas sensor is fabricated. In that case, after the local formation of the Porous Silicon areas (2) an insulating layer (3) is deposited, as shown in Fig. 3A. The insulating layer can be either SiO₂, or Si₃N₄ or any combination of them. However, it is desirable to use an insulating material with very low thermal conductivity. A heater (8) is formed on top of the said insulating layer (3) (Fig. 3A). The heater is made either of doped polycrystalline silicon or any conducting layer or layer combination, as for example Pt/Ti. An insulating layer 9 is then deposited on top of the heater (8) (Fig: 3B). The deposition method of the said insulating layer (9) depends on the nature of the heater. For example if the heater is made from polycrystalline silicon, the insulating layer can be SiO₂ deposited by LPCVD or LTO techniques. A catalytic layer (10) is then deposited on top of the said insulating layer (9) (Fig. 3B). For the particular embodiment described, the selection of the catalytic material can be made over a vast range of materials, such as Pt, Pd for example. The choice of the catalytic material will depend on the properties of the gas to be detected The only limitation for the catalytic material, according to the methodology described in the present invention, is to remain unaffected by the processes that follow, and particularly by the removal of the photoresist, which can be performed either by using wet techniques (for example by exposure to organic solvents such as acetone) or dry etching techniques (for example O₂ plasma). The patterning of the catalytic layer can be achieved either by the lift-off technique or by standard photolithography techniques combined with wet etching, if needed. The temperature change from the heat that is generated or absorbed from the catalytic reaction of the gases on the surface of the catalytic layer (10) can be detected, either by the heated resistor (8) or by a second resistor, a sensing resistor, that is implemented in the device (not shown on Fig. 3). In other embodiments, integrated thermopiles can be used to detect the temperature changes due to the catalytic reaction,

or a thermal serving element in the form of a plurality of thermocouples may be provided the contact of each of the thermocouples being located on the suspended porous silicon membrane and the other being located on the silicon substrate.

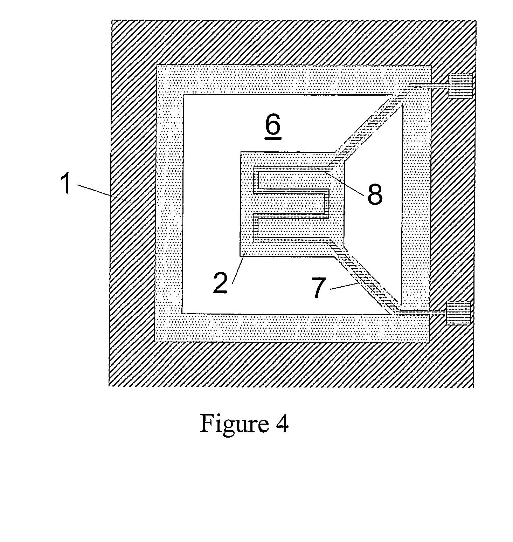

After the deposition and patterning of the said catalytic material (10), photoresist (4) is deposited on top of the wafer and etch windows (5) are opened using standard photolithography techniques, as shown in Fig. 3C. The release of the Porous Silicon membrane is performed as described previously. Fig. 3C shows a cross section schematic drawing of the gas sensor, where we can see the cavity (6) that is formed under the porous silicon (2). Fig. 4 shows a plan view drawing of the device, where we can see the silicon substrate (1), the porous silicon membrane (2), the porous silicon supporting beams (7) and an indicative design of the heater (8).

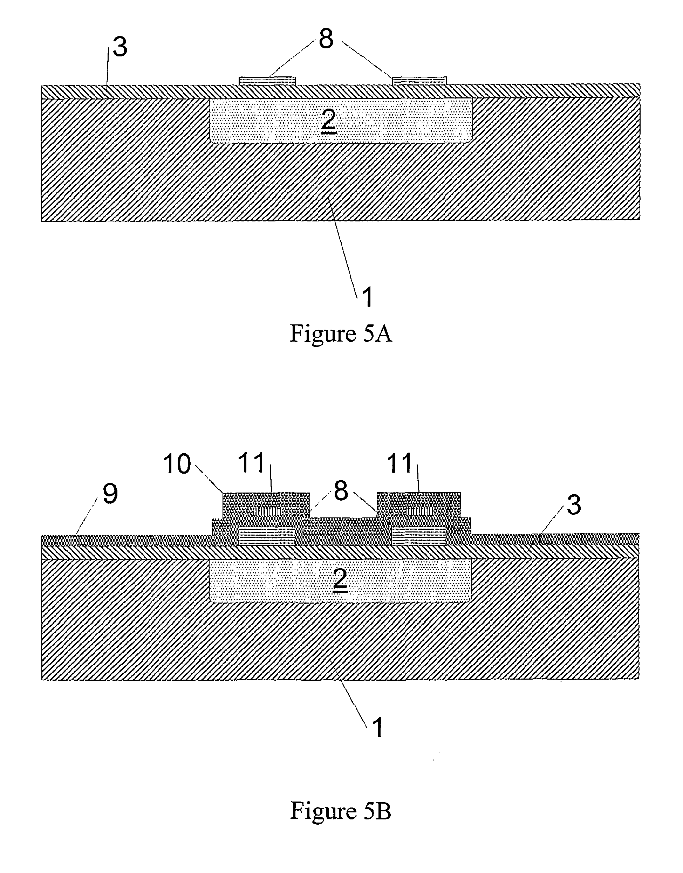

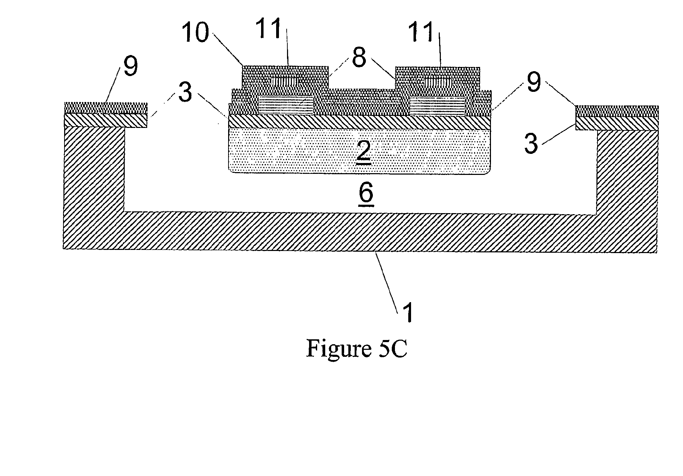

In another embodiment of the present invention, a conductometric type gas sensor is fabricated. The fabrication process for the formation of the porous silicon area (2) and the heater (8) is similar to the process described above (Fig 5A). After the deposition of the isolation layer (9) on top of the heater, conductive electrodes (11) are deposited and patterned (Fig. 5B). The catalytic material (10) is deposited on top of the electrodes (Fig. 5B). The choice of the catalytic material depends on the gas to be detected and can be selected by a large range of materials (SnO₂ for example) or any material whose 50 electrical characteristics depend on the ambient gas. The release of the porous silicon membrane is performed in the way described previously. Fig. 5C shows a cross sectional schematic drawing of the gas sensor after the release of the porous silicon membrane, where we can see the cavity (6) formed under the porous silicon membrane (2).

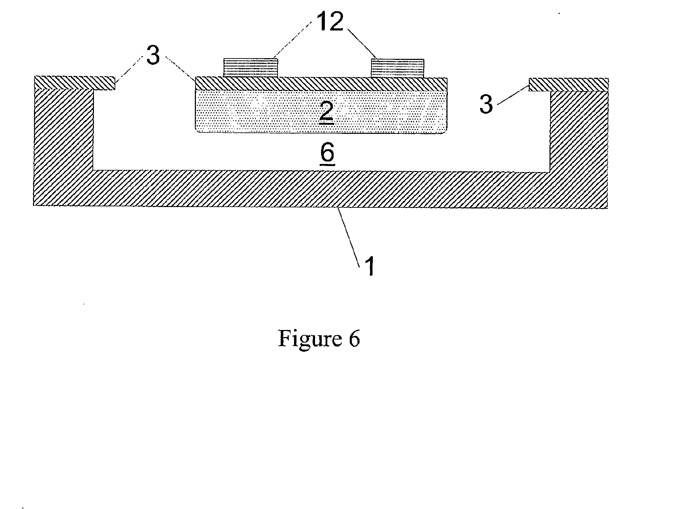

In another embodiment of the present invention, a thermal conductivity sensor can be formed by depositing a Pt resistor (12) on top of a Porous Silicon membrane (2) suspended over the cavity (6), as illustrated in Fig. 6. An insulating layer (3) may exist between the resistor and the Porous Silicon membrane (2). The dimensions of the suspended porous silicon membrane (2) can be changed in order to modulate the response time of the sensor.

Although the description we have provided up to now has focused on the release of porous silicon membranes, it is possible to use the method described in this invention for the release of suspended membranes that are made of silicon oxide, nitride or any stack of these materials, due to the high selectivity of dry etching of Si with respect to SiO₂/Si₃N₄. With a slightly modified fabrication process, polycrystalline silicon membranes can be also released.

The present invention has been described in terms of a number of preferred embodiments. The invention is not limited to the embodiments depicted and described. The scope of the invention is defined by the appended claims.

## Claims

1. A front-side silicon micromachining process for the fabrication of suspended porous silicon membranes in the form of bridges or cantilevers comprising
forming a porous silicon membrane (2) in at least one predetermined area of a silicon substrate (1);
defining etch windows (5) around the edge of or inside the porous silicon membrane (2) using standard photo lithography;
thereafter selectively etching from the front side the silicon substrate (1) underneath the porous silicon membrane (2) using dry etching techniques to release the porous silicon membrane (2) and to form a cavity (6) under the porous silicon membrane (2).

2. A front-side silicon micromachining process as claimed in Claim 1 wherein a patterned conductive layer (8) is formed on top of the porous silicon membrane (2).

3. A gas sensor device comprising a silicon substrate (1), a porous silicon membrane (2) suspended over a cavity (6) formed in the silicon substrate (1), to provide local thermal isolation, and a patterned conductive layer (8) provided on top of the suspended membrane (2), **characterized in that** the membrane (2) is suspended by one or several porous silicon supporting beams (7) which are formed integrally with the membrane.

4. A gas sensor device as claimed in Claim 3 wherein an electrically insulating layer (3) is provided on top of the conductive layer (8), a catalytic material (10) is provided on top of the insulating layer (3) and a thermal sensing element to sense the change in temperature when ambient gas reacts with the catalytic material (10).

5. A gas sensor device as claimed in Claim 4 wherein the thermal sensing element is a Pt resistor.

6. A gas sensor device as claimed in Claim 4 wherein the thermal sensing element includes a plurality of thermocouples, one contact of each of the thermocouples being located on the suspended porous silicon membrane (2) and the other being located on the silicon substrate (1).

7. A gas sensor device as claimed in Claim 3 wherein an electrically insulating layer (3) is provided on top of the conductive layer (8), metal electrodes (11) are provided on top of the insulating layer (3) and a catalytic material (10) is provided on top of the electrodes (11), the resistivity of the catalytic material (10) being dependent on the ambient gas.

8. A gas sensor device as claimed in Claim 3 wherein the patterned conductive layer (8) is a Pt resistor.

## Patentansprüche

1. Eine forderseitliche Mikromechanische Technik für die Fabrikation von schwebenden Membranen aus porösen Silizium, in eine Form wie eine Brücke oder ein Kragarm, die enthält
eine poröse Silizium-Membran (2) in mindestens einen vorbestimmten Gebiet auf einen Silizium-Substrat (1) formen;
Ätz-Fenstern (5) rundum oder innerhalb des Randes der poröse Silizium-Membran (2) mit der Verwendung des klassischen Fotolithografie-Verfahren definieren;
Danach selektives ätzen des Silizium-Substrates (1) unterhalb der poröse Silizium-Membran (2) mit der Verwendung von Trocken-Ätz Techniken um die poröse Silizium-Membran (2) frei zu setzen und einen Hohlraum (6) unterhalb der poröse Silizium-Membran (2) zu formen.

2. Eine forderseitliche Mikromechanische Technik wie in Anspruch 1 beansprucht wird, in der ein gestaltenen leitenden Schicht (8) auf die poröse Silizium-Membran (2) geformt wird.

3. Ein Gas-Sensor der ein Silizium-Substrat (1), eine über einen auf Silizium-Substrat (1) geformten Hohlraum (6) schwebende poröse Silizium-Membran (2) enthält, um lokale thermische Isolierung zu bieten, und eine gestaltene leitende Schicht (8) auf die Oberseite der schwebende poröse Silizium-Membran (2) sich befindet, charakterisiert in dem die Silizium-Membran (2) durch einen oder mehrere stützende Balken (7) schwebt, die integral mit die Silizium-Membran (2) geformt sind.

4. Ein Gas-Sensor wie in Anspruch 3 beansprucht wird, worin sich eine elektrisch isolierende Schicht (3) auf die Oberseite der leitende Schicht (8) befindet, ein katalytisches Material (10) auf die Oberseite der isolierende Schicht (3) vorhandet ist und ein thermisches Mess-Element das die Veränderung der Temperatur fühlt wenn umgebendes Gas mit dem katalytischen Material (10) reagiert.

5. Ein Gas-Sensor wie in Anspruch 4 beansprucht wird, worin das thermische Mess-Element ein Pt-Widerstand ist.

6. Ein Gas-Sensor wie in Anspruch 4 beansprucht wird, worin das thermische Mess-Element eine Mehrheit aus Thermo-Paare beeinhält, wo der eine Kontakt jedes Thermo-Paares auf die schwebende poröse Silizium-Membran (2) und der andere auf das Silizium-Substrat (1) sich befindet.

7. Ein Gas-Sensor wie in Anspruch 3 beansprucht wird, worin eine elektrisch isolierende Schicht (3) auf die Oberseite der leitende Schicht (8), metalische Elektroden (11) auf die Oberseite der solierende Schicht (3) und ein katalytisches Material (10) auf die Oberseite der Elekroden (11) vorhanden sind, wobei der spezifische Widerstand des katalytisches Materiales von den umgebenden Gas abhängig ist.

8. Ein Gas-Sensor wie in Anspruch 3 beansprucht wird, worin die gestaltene leitende Schicht (8) ein Pt-Widerstand ist.

## Revendications

1. Procédé de micro-usinage de substrat de silicium sur la face avant pour la fabrication de membranes suspendues à base de silicium poreux et en forme de ponts ou de cantilevers comprenant
la formation d'une membrane de silicium poreux (2) sur au moins une région prédéfinie d'un substrat de silicium (1);
la définition des fenêtres de gravure (5) autour des bords ou dans la membrane de silicium poreux (2) en utilisant la photolithographie standard; ensuite la gravure sélective du substrat de silicium (1) de la face avant sous
la membrane du silicium poreux (2) en utilisant des techniques de gravure sèche afin de dégager la membrane de silicium poreux (2) et de former une cavité (6) sous la membrane de silicium poreux (2).

2. Procédé de micro-usinage de silicium sur la face avant comme revendique' dans la reendication 1, où la piste d'une couche conductrice (8) est formée au dessus de la membrane du silicium poreux (2).

3. Capteur de gaz comprenant un substrat de silicium (1), une membrane de silicium poreux (2) suspendue au dessus d'une cavité (6) formée sur le substrat de silicium (1), afin de fournir une isolation thermique locale et une piste d'une couche conductrice (8) fournie au dessus de la membrane suspendue (2), **caracterisee en ce que** la membrane (2) est suspendue d'un ou plusieurs supports à silicium poreux (7) qui sont formés intégralement avec la membrane.

4. Capteur de gaz comme revendique' dans la revendication 3 où une couche électriquement isolatrice (3) est fournie au dessus de la couche conductrice (8), un matériel catalytique (10) est fourni au dessus de la couche isolatrice (3) et un capteur thermique qui détecte les changements de température lorsque le gaz d'atmosphère réagit avec le matériel catalytique (10).

5. Capteur de gaz comme revendique' dans la revendication 4 où le capteur thermique est une résistance de Pt.

6. Capteur de gaz comme revendique' dans la revendication 4 où le capteur thermique inclut une multitude de thermocouples, dont un contact de chaque thermocouple est localisé sur la membrane suspendue de silicium poreux (2) et l'autre est localisé sur le substrat de silicium (1),

7. Capteur de gaz comme revendique' dans la revendication 3 où une couche électriquement isolatrice (3) est fournie au dessus de la couche conductrice (8), des électrodes métalliques (11) sont fournis au dessus de la couche isolatrice (3) et un matériel catalytique (10) est fourni au dessus des électrodes (11), la résistivité du matériau catalytique (10) étant dépendante du gaz d'atmosphère.

8. Capteur de gaz comme revendique' dans la revendication 3 où la piste de la couche conductrice (8) est une résistance de Pt.
